# EUROPEAN PATENT APPLICATION

(11) **EP 4 704 294 A1**
(43) Date of publication of application: **04.03.2026**
(21) Application number: 25188052.2
(22) Date of filing: 08.07.2025
(51) Int. Cl.: H02J 7/00, H01M 10/42

(54) **BATTERY MANAGEMENT DEVICE, ENERGY STORAGE DEVICE INCLUDING SAME AND CONTROLLING METHOD OF ENERGY STORAGE DEVICE**

(30) Priority: 27.08.2024 KR 20240114796
(71) Applicant: SAMSUNG SDI CO., LTD., Yongin-si, Gyeonggi-do 17084 (KR)
(72) Inventor: KANG, Dongyoun, 17084 Yongin-si, Gyeonggi-do (KR); LA, Taehyoung, 17084 Yongin-si, Gyeonggi-do (KR)
(74) Representative: Gulde & Partner

(57) **Abstract**

Disclosed is a battery management device (100) including a detection circuit (110) configured to detect a state of a battery (102), and a control circuit (120) configured to monitor the state of the battery (102) and configured to control functions associated with the battery (102), wherein the control circuit (120) is configured to transmit turn-on signals at a predetermined time interval to each of a first switch (106) and a second switch (108) that electrically connect or disconnect the battery (102) and a power supply (104) in response to a start signal associated with charging or discharging of the battery (102).

## Description

### FIELD

Aspects of embodiments of the present disclosure relate to a battery management device, an energy storage device including the same, and a controlling method of the energy storage device.

### BACKGROUND

Unlike primary batteries that are not designed to be (re)charged, secondary (or rechargeable) batteries are batteries that are designed to be discharged and recharged. Low\-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

These secondary batteries can be used as a battery pack including a battery module in which a plurality of battery cells is connected in series and/or in parallel. Further, a plurality of battery modules or battery packs can be connected in series/parallel to form a battery rack, and a plurality of battery racks can be connected in parallel to form a battery container. Moreover, such a battery container can be used as an energy storage system (ESS) (or energy storage device).

The energy storage system can connect renewable energy sources such as wind, solar power, or the like, whose power generation output cannot be controlled, to an existing power grid and charge or discharge energy according to the power consumption pattern. In particular, a battery energy storage system using secondary batteries can not only be used to stabilize system voltage and frequency, but also store surplus energy in conjunction with a renewable energy generation system whose power generation output is not consistent, such as wind, solar power, or the like, and discharge the energy stored in the batteries to supply energy to a load.

The above information disclosed in this Background section is for enhancement of understanding of the background of the present disclosure, and therefore, it may contain information that does not constitute related (or prior) art.

### SUMMARY

Aspects of the present disclosure provide a battery management device, an energy storage device including same and a controlling method of the energy storage device to solve the above technical problem.

These and other aspects and features of the present disclosure will be described in or will be apparent from the following description of embodiments of the present disclosure.

To solve the above technical problem, a battery management device according to an aspect of the present disclosure includes a detection circuit configured to detect a state of a battery, and a control circuit configured to monitor the state of the battery and configure to control functions associated with the battery. The control circuit is configured to transmit a turn-on signal or turn-on signals at a predetermined time interval to each of a first switch and a second switch that electrically connect or disconnect the battery and a power supply in response to a start signal associated with charging or discharging of the battery. Hence, as the two switches are switched after each other with the predetermined time interval between the switch events, the inrush current to or from the battery is reduced.

According to some embodiments of the present disclosure, the predetermined time interval may be determined based on an inrush current due to an electrical connection between the battery and the power supply. An advantage of this may be that simultaneous switching due to inappropriate intervals and/or unnecessary long intervals are avoided.

An energy storage device according to another aspect of the present disclosure includes a first battery container including a plurality of first battery racks connected in parallel to one another, and a first power supply that supplies power to the plurality of first battery racks. The energy storage device comprises a first battery management device, wherein the first battery management device is configured to transmit a turn-on signal or turn-on signals at a predetermined first time interval to each of a plurality of first switch units that electrically connect or disconnect each of the plurality of first battery racks and the first power supply in response to a start signal associated with charging or discharging of the plurality of first battery racks. Hence, as the first switch units are switched after each other with the predetermined time interval between the switch events, om the first battery racks are connected after each other, which reduces inrush current. The first battery management device may be the battery management device of the previous aspect.

According to some embodiments of the present disclosure, the predetermined first time interval may be determined based on the number of the plurality of first battery racks and/or an inrush current due to an electrical connection between each of the plurality of first battery racks and the first power supply. An advantage of this may be that simultaneous switching due to inappropriate intervals and/or unnecessary long intervals are avoided.

According to some embodiments of the present disclosure, each of the plurality of first switch units may include a 1-1 or first switch and a 1-2 or second switch that electrically connect or disconnect a corresponding battery rack of the plurality of first battery racks and the first power supply. The first battery management device may be configured to transmit a turn-on signal or turn-on signals at a predetermined second time interval to each of the 1-1 or first switch and the 1-2 second switch in response to a start signal associated with charging or discharging of the battery rack. An advantage of this may be that simultaneous switching due to inappropriate intervals and/or unnecessary long intervals are avoided.

According to some embodiments of the present disclosure, the first battery management device may be included in the first battery container. An advantage of this may be that time delay due to long distances between the first battery management device and the switch units, which could affect the temporal separation of switch events, is avoided or at least reduced.

The energy storage device according to some embodiments of the present disclosure may further include a second battery container including a plurality of second battery racks connected in parallel to one another and a second power supply that supplies power to the plurality of second battery racks. An advantage of this may be that more energy can be stored.

According to some embodiments of the present disclosure, the first battery management device may be configured to transmit a turn-on signal or turn-on signals at a predetermined third time interval to each of a plurality of second switch units that electrically connect or disconnect each of the plurality of second battery racks and the second power supply in response to a start signal associated with charging or discharging of the plurality of second battery racks. An advantage of this may be that simultaneous switching is avoided, thereby reducing inrush current.

According to some embodiments of the present disclosure, the predetermined third time interval may be determined based on the number of the plurality of second battery racks and/or an inrush current due to an electrical connection between each of the plurality of second battery racks and the second power supply. An advantage of this may be that simultaneous switching due to inappropriate intervals and/or unnecessary long intervals are avoided.

According to some embodiments of the present disclosure, the predetermined third time interval may be approximately the same as the predetermined first time interval. An advantage of this may be that controlling several battery racks is simplified.

According to some embodiments of the present disclosure, the first battery container may further include a second battery management device. The second battery management device may be configured to control functions associated with the first battery container. The second battery container may further include a third battery management device. The third battery management device may be configured to control functions associated with the second battery container. The first battery management device may be configured to receive first configuration information including identification information of each of the plurality of first battery racks. The first battery management device may be configured to receive information on the number of the plurality of first battery racks from the second battery management device. The first battery management device may be configured to determine a first order of the plurality of first battery racks based on the first configuration information. The first battery management device may be configured to receive second configuration information including identification information of each of the plurality of second battery racks. The first battery management device may be configured to receive information on the number of the plurality of second battery racks from the third battery management device. The first battery management device may be configured to determine a second order of the plurality of second battery racks based on the second configuration information. The first and/or second battery racks may be switched in the determined orders. An advantage of this may be that various battery racks can be switched in a concerted manner, avoiding too high inrush currents.

According to some embodiments of the present disclosure, the first battery management device may be configured to transmit a turn-on signal or turn-on signals in sequence at the predetermined first time interval to each of the plurality of first switch units based on the determined first order. The first battery management device may be configured to transmit a turn-on signal or turn-on signals in sequence at the predetermined third time interval to each of the plurality of second switch units based on the determined second order. An advantage of this may be that various battery racks can be switched in a concerted manner, avoiding too high inrush currents.

According to some embodiments of the present disclosure, the first battery management device may be configured to match an n-th battery rack according to the first order among the plurality of first battery racks with the n-th battery rack according to the second order among the plurality of second battery racks. "n" may be a natural number. The natural number "n" may be a number of the number of the plurality of first battery racks and the number of the plurality of second battery racks. The natural number "n" may be a number smaller than the total number of the plurality of first battery racks and the total number of the plurality of second battery racks. The first battery management device may be configured to transmit a turn-on signal or turn-on signals simultaneously to a first switch unit associated with the matched battery rack of the plurality of first switch units and a second switch unit associated with the matched battery rack of the plurality of second switch units. An advantage of this may be that various battery racks can be switched in a concerted manner, avoiding too high inrush currents, while efficiently switching multiple battery racks.

A method of controlling an energy storage device according to yet another aspect of the present disclosure includes receiving a start signal associated with charging or discharging of a plurality of first battery racks included in a first battery container and connected in parallel to each other. The method comprises transmitting a turn-on signal or turn-on signals at a predetermined first time interval to each of a plurality of first switch units that electrically connects or disconnects each of the plurality of first battery racks and a first power supply included in the first battery container and supplying power to the plurality of first battery racks, in response to the received start signal. Hence, as the first switch units are switched after each other with the predetermined time interval between the switch events, om the first battery racks are connected after each other, which reduces inrush current.

According to some embodiments of the present disclosure, the predetermined first time interval may be determined based on the number of the plurality of first battery racks and/or an inrush current due to an electrical connection between each of the plurality of first battery racks and the first power supply. An advantage of this may be that simultaneous switching due to inappropriate intervals and/or unnecessary long intervals are avoided.

According to some embodiments of the present disclosure, each of the plurality of first switch units may include a 1-1 switch or first switch and a 1-2 switch or second switch that electrically connect or disconnect a corresponding battery rack of the plurality of first battery racks and the first power supply. Transmitting the turn-on signal or the turn-on signals to each of the plurality of first switch units may include transmitting a turn-on signal or turn-on signals at a predetermined second time interval to each of the 1-1 or first switch and the 1-2 or second switch in response to a start signal associated with charging or discharging of the battery rack. An advantage of this may be that simultaneous switching due to inappropriate intervals and/or unnecessary long intervals are avoided.

The method of controlling an energy storage device according to some embodiments of the present disclosure may further include receiving a start signal associated with charging or discharging of a plurality of second battery racks included in a second battery container, the second battery container being different from the first battery container, wherein the first and second battery containers are connected in parallel to each other. The method may further comprise transmitting a turn-on signal or turn-on signals at a predetermined second time interval to each of a plurality of second switch units that electrically connects or disconnects each of the plurality of second battery racks and a second power supply included in the second battery container, and supplying power to the plurality of second battery racks, in response to the received start signal. An advantage of this may be that more energy can be stored.

The method of controlling an energy storage device according to some embodiments of the present disclosure may further include receiving first configuration information. The first configuration information may include identification information of each of the plurality of first battery racks, and information on the number of the plurality of first battery racks from a battery management device included in the first battery container. The method may include determining a first order of the plurality of first battery racks based on the first configuration information. The method may include receiving second configuration information including identification information of each of the plurality of second battery racks, and information on the number of the plurality of second battery racks from a battery management device included in the second battery container. The method may include determining a second order of the plurality of second battery racks based on the second configuration information. An advantage of this may be that various battery racks can be switched in a concerted manner, avoiding too high inrush currents.

According to some embodiments of the present disclosure, the transmitting the turn-on signal or the turn-on signals to each of the plurality of first switch units may include transmitting a turn-on signal or turn-on signals in sequence at the predetermined first time interval to each of the plurality of first switch units based on the determined first order. Transmitting the turn-on signal or the turn-on signals to each of the plurality of second switch units may include transmitting a turn-on signal or turn-on signals in sequence at the predetermined second time interval to each of the plurality of second switch units based on the determined second order. An advantage of this may be that various battery racks can be switched in a concerted manner, avoiding too high inrush currents.

The method of controlling an energy storage device according to some embodiments of the present disclosure may further include matching an n-th battery rack according to the first order among the plurality of first battery racks with the n-th battery rack according to the second order among the plurality of second battery racks. "n" may be a natural number. The natural number "n" may be a number of the number of the plurality of first battery racks and the number of the plurality of second battery racks. The natural number "n" may be a number smaller than the total number of the plurality of first battery racks and the total number of the plurality of second battery racks. Transmitting the turn-on signal or the turn-on signals in sequence at the predetermined second time interval to each of the plurality of second switch units may include transmitting a turn-on signal or turn-on signals to a first switch unit associated with the matched battery rack of the plurality of first switch units simultaneously with transmitting a turn-on signal or turn-on signals to a second switch unit associated with the matched battery rack of the plurality of second switch units. An advantage of this may be that various battery racks can be switched in a concerted manner, avoiding too high inrush currents, while efficiently switching multiple battery racks.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

### BRIEF DESCRIPTION OF THE DRAWINGS

The following schematic drawings attached to this specification illustrate exemplary embodiments of the present disclosure, and further describe aspects and features of the present disclosure together with the detailed description of the present disclosure. Thus, the present disclosure should not be construed as being limited to the drawings:
FIG. 1 is a diagram for describing the configuration of a battery management device according to some embodiments of the present disclosure;
FIG. 2 is a diagram for describing the configuration of an energy storage device according to some embodiments of the present disclosure;
FIG. 3 is a block diagram schematically illustrating an energy storage device according to some embodiments of the present disclosure;
FIG. 4 is a diagram for describing the configuration of an energy storage device including a plurality of battery containers according to some embodiments of the present disclosure;
FIG. 5 is a diagram for describing a method for determining the order of battery racks according to some embodiments of the present disclosure;
FIG. 6 is a diagram for describing a method for determining the order of different numbers of battery racks according to some embodiments of the present disclosure;
FIG. 7 is a diagram for describing the magnitude of inrush currents according to transmission time intervals of turn-on signals according to some embodiments of the present disclosure;
FIG. 8 is a diagram for describing a method of controlling a battery management device according to some embodiments of the present disclosure; and
FIG. 9 is a diagram for describing a method of controlling an energy storage device according to some embodiments of the present disclosure.

### DETAILED DESCRIPTION

Hereinafter, embodiments of the present disclosure will be described, in detail, with reference to the accompanying drawings.

The embodiments described in this specification and the configurations shown in the drawings are only some of the embodiments of the present disclosure and do not represent all of the technical ideas, aspects, and features of the present disclosure. Accordingly, it should be understood that there may be various modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In an energy storage system, efficient management of the batteries is one of the important factors. For example, by managing various matters such as charging, discharging, and cell balancing of batteries, the service life of the batteries can be extended, and power can be stably supplied to loads. To this end, the energy storage system may include a battery management system (BMS) (or battery management device).

Further, the energy storage system may include a power supply that supplies power to peripheral devices, including a BCU (battery controller unit) of an internal battery rack. Such a power supply can use a switching mode power supply (SMPS), and the specifications of the SMPS can be determined by taking into account the magnitude of the inrush current. Accordingly, in order to reduce the capacity of a power supply, it is desirable to develop technology for a battery management device capable of reducing inrush currents, an energy storage device including the same, and a method of controlling the energy storage device. xxx

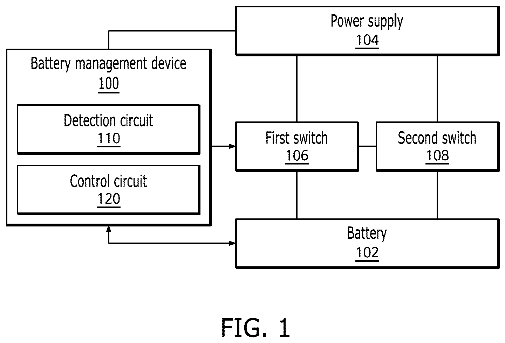

FIG. 1 is a diagram illustrating the configuration of a battery management device 100 according to some embodiments of the present disclosure. Referring to FIG. 1, the battery management device 100 (or battery management system) may manage a battery 102. The battery management device 100 may include a detection circuit 110 and a control circuit 120. However, the configuration of the battery management device 100 is not limited thereto. According to various embodiments, the battery management device 100 may further include at least one other component in addition to the components described above. For example, the battery management device 100 may further include a balancing circuit (or balancing device) that performs a balancing operation of the battery 102, battery modules and/or battery cells constituting the battery 102.

The detection circuit 110 (or detection device) may detect the states (e.g., voltage, current, temperature, etc.) of the battery 102. As one example, the detection circuit 110 may detect the voltage of each cell or each battery module constituting the battery 102. As another example, the detection circuit 110 may detect the current flowing through a battery module or each battery module constituting a battery pack. As yet another example, the detection circuit 110 may detect the temperature of cells, modules, and/or surroundings at at least one point of the battery 102.

The control circuit 120 (or control device) may monitor the states of the battery 102 and control functions associated with the battery 102. For example, the control circuit 120 may monitor and calculate the voltage, current, temperature, state of charge (SOC), state of health (SOH), etc., of the battery 102 based on the states of the battery 102 detected via the detection circuit 110. Further, the control circuit 120 may perform temperature control, balancing control, charge/discharge control, etc., based on the monitoring results. Moreover, the control circuit 120 may perform a protection function (e.g., over-discharge, over-charge, over-current prevention, short-circuit, extinguishing function, etc.) based on the monitoring results. Furthermore, the control circuit 120 may perform a wired or wireless communication function with external devices (e.g., a higher-level controller, a vehicle, a charger, a power conversion device, etc.) of the battery 102, battery module, or battery pack.

According to some embodiments, the control circuit 120 may be configured to transmit at least one turn-on signal at a predetermined time interval to each of a first switch 106 and a second switch 108 that electrically connect or disconnect (or selectively connect) the battery 102 and the power supply 104 (e.g., SMPS) in response to a start signal associated with charging or discharging of the battery 102. In the following, it is referred to a tun-on signal that is transmitted at different times with time intervals therebetween. Yet, in selected or in all of the exemplary embodiments, turn-on signals may be transmitted instead of a turn-on signal, the turn-on signals being transmitted after each other with time intervals therebetween. Here, the first switch 106 and the second switch 108 may include a DC contactor. For example, the control circuit 120 may transmit a turn-on signal to the first switch 106 in response to a start signal associated with charging or discharging of the battery 102, and transmit a turn-on signal to the second switch 108 when a predetermined time has elapsed since transmitting the turn-on signal to the first switch 106. At this time, the transmission time interval of the turn-on signals transmitted to each of the first switch 106 and the second switch 108 may be determined based on the inrush current due to the electrical connection between the battery 102 and the power supply 104. In this way, the inrush current can be reduced by transmitting turn-on signals at a predetermined time interval to each of the switches 106 and 108 that electrically connect or disconnect the battery 102 and the power supply 104, and as the inrush current is reduced, the capacity of the power supply 104 can also be designed to be smaller.

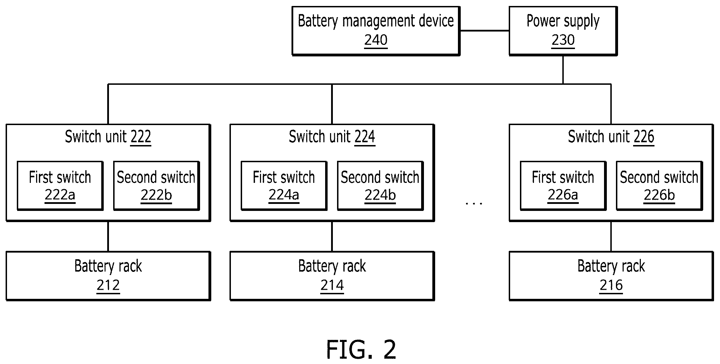

FIG. 2 is a diagram illustrating the configuration of an energy storage device according to some embodiments of the present disclosure. Referring to FIG. 2, the energy storage device (or energy storage system) may include a plurality of battery racks 212, 214, and 216, a plurality of switch units 222, 224, and 226, a power supply 230, and a battery management device 240. However, the configuration of the energy storage device is not limited thereto. According to various embodiments, the energy storage device may further include at least one other component in addition to the components described above.

Each of the plurality of battery racks 212, 214, and 216 may be formed by having multiple battery modules in which a plurality of battery cells is connected in series and/or parallel or multiple battery packs including the same connected in series/parallel. Further, the plurality of battery racks 212, 214, and 216 may be connected in parallel to each other.

The plurality of switch units 222, 224, and 226 may electrically connect or disconnect (or selectively connect) each of the plurality of battery racks 212, 214, and 216 and the power supply 230. The plurality of switch units 222, 224, and 226 may each include two switches. For example, each of the plurality of switch units 222, 224, and 226 may include a first switch 222a, 224a, or 226a and a second switch 222b, 224b, or 226b that electrically connect or disconnect (or selectively connect) the corresponding battery rack and the power supply 230. The first switches 222a, 224a, and 226a and the second switches 222b, 224b, and 226b may include, for example, a DC contactor.

The power supply 230 may supply power to the plurality of battery racks 212, 214, and 216 and the battery management device 240. The power supply 230 may include, for example, an SMPS.

The battery management device 240 may manage battery cells within the plurality of battery racks 212, 214, and 216. According to some embodiments, the battery management device 240 may be configured to transmit a turn-on signal at a predetermined first time interval to each of the plurality of switch units 222, 224, and 226 that electrically connects or disconnects each of the plurality of battery racks 212, 214, and 216 and the power supply 230 in response to a start signal associated with charging or discharging of the plurality of battery racks 212, 214, and 216. For example, the battery management device 240 may transmit a turn-on signal to a first switch unit 222 connected between a first battery rack 212 and the power supply 230 among the plurality of switch units 222, 224, and 226 in response to a start signal associated with charging or discharging of the plurality of battery racks 212, 214, and 216, and may transmit a turn-on signal to a second switch unit 224 connected between a second battery rack 214 and the power supply 230 among the plurality of switch units 222, 224, and 226 when a predetermined first time has elapsed since transmitting the turn-on signal to the first switch unit 222. In this way, the battery management device 240 may transmit a turn-on signal at a predetermined first time interval to each of the plurality of switch units 222, 224, and 226 up to an n-th switch unit 226 connected between an n-th battery rack 216 and the power supply 230. At this time, the transmission time interval (first time interval) of the turn-on signals transmitted to each of the plurality of switch units 222, 224, and 226 may be determined based on at least one of the number of the plurality of battery racks 212, 214, and 216 or the inrush current due to the electrical connection between each of the plurality of battery racks 212, 214, and 216 and the power supply 230. In this way, the inrush current can be reduced by transmitting turn-on signals at a predetermined time interval to each of the plurality of switch units 222, 224, and 226 that electrically connects or disconnects the power supply 230 and each of the plurality of battery racks 212, 214, and 216, and as the inrush current is reduced, the capacity of the power supply 230 can also be designed to be smaller.

According to some embodiments, the battery management device 240 may be configured to transmit a turn-on signal at a predetermined second time interval to each of the first switch 222a, 224a, or 226a and the second switch 222b, 224b, or 226b that electrically connect or disconnect (or selectively connect) the corresponding battery rack and the power supply 230 in response to a start signal associated with charging or discharging of each of the plurality of battery racks 212, 214, and 216. For example, the battery management device 240 may transmit a turn-on signal to the first switch 222a between the first battery rack 212 and the power supply 230 in response to a start signal associated with charging or discharging of the first battery rack 212, and transmit a turn-on signal to the second switch 222b when a predetermined second time has elapsed since transmitting the turn-on signal to the first switch 222a. Further, the battery management device 240 may transmit a turn-on signal to the first switch 224a between the second battery rack 214 and the power supply 230 in response to a start signal associated with charging or discharging of the second battery rack 214, and transmit a turn-on signal to the second switch 224b when the predetermined second time has elapsed since transmitting the turn-on signal to the first switch 224a. In this way, the battery management device 240 may transmit a turn-on signal to the first switch 226a between the n-th battery rack 216 and the power supply 230 in response to a start signal associated with charging or discharging of the n-th battery rack 216, and transmit a turn-on signal to the second switch 226b when the predetermined second time has elapsed since transmitting the turn-on signal to the first switch 226a, up to the n-th battery rack 216. At this time, the transmission time interval (second time interval) of the turn-on signals transmitted to the first switch 222a, 224a, or 226a and the second switch 222b, 224b, or 226b included in each of the plurality of switch units 222, 224, and 226 may be determined based on the inrush current due to the electrical connection between the corresponding battery rack and the power supply 230. In this way, not only can turn-on signals be transmitted to the plurality of switch units 222, 224, and 226, at the predetermined time interval (first time interval) between them, connected between each of the plurality of battery racks 212, 214, and 216 and the power supply 230, but also turn-on signals can be transmitted to the first switch 222a, 224a, or 226a and the second switch 222b, 224b, or 226b, at the predetermined time interval (second time interval) between them, included in each of the plurality of switch units 222, 224, and 226. Accordingly, the inrush current can be reduced, and as the inrush current is reduced, the capacity of the power supply 230 can also be designed to be smaller.

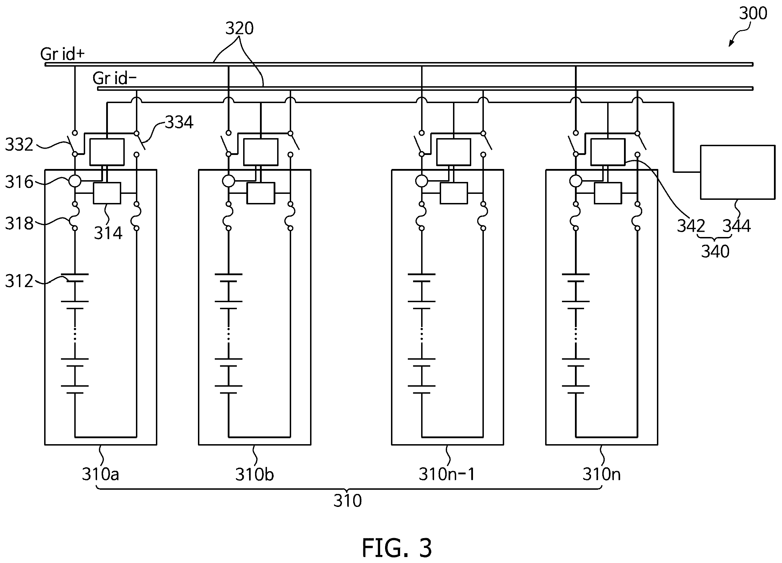

FIG. 3 is a block diagram schematically illustrating an energy storage device 300 according to some embodiments of the present disclosure. Referring to FIG. 3, the energy storage device 300 (or energy storage system) may include a plurality of battery racks 310 (e.g., the battery racks 212, 214, and 216 in FIG. 2), a grid 320 to which the plurality of battery racks 310 is connected in parallel, a first switch 332 (e.g., the first switches 222a, 224a, and 226a in FIG. 2) and a second switch 334 (e.g., the second switches 222b, 224b, and 226b in FIG. 2) that electrically connect or disconnect (or selectively connect) each of the plurality of battery racks 310 and the grid 320, and a battery management device 340 (e.g., the battery management device 240 in FIG. 2) that controls the plurality of battery racks 310, the first switch 332, and the second switch 334. However, the configuration of the energy storage device 300 is not limited thereto. According to various embodiments, the energy storage device 300 may omit at least one of the components described above, and may further include at least one other component.

Each of the plurality of battery racks 310 may include multiple battery cells 312, a voltage sensor 314, a current sensor 316, and a fuse 318 connected in series. The multiple battery cells 312 may be arranged in series inside each of the plurality of battery racks 310, and may be formed of secondary batteries capable of charging and discharging.

The voltage sensor 314 may be connected to the positive and negative electrodes of the battery cells 312, respectively, and measure the voltage of the entire multiple battery cells 312 connected in series and transfer it to the battery management device 340.

The current sensor 316 may be connected to the positive electrode of the battery cell 312, and measure the current of the entire multiple battery cells 312 connected in series and transfer it to the battery management device 340.

The fuse 318 may be connected to the positive and negative electrodes of the battery cell 312, respectively, and protect the battery cell 312 from damage caused by overcurrent and overvoltage.

The plurality of battery racks 310 may be connected in parallel to the grid 320. Here, the grid 320 may provide a charging and discharging path to the plurality of battery racks 310.

The first switch 332 and the second switch 334 may be connected to each of the plurality of battery racks 310, the grid 320, and the battery management device 340. The first switch 332 and the second switch 334 may receive a control signal from the battery management device 340 and electrically connect or disconnect (or selectively connect) each of the plurality of battery racks 310 and the grid 320. The first switch 332 and the second switch 334 may include, for example, a DC contactor.

The battery management device 340 may include a first battery management device 344 and a plurality of second battery management devices 342. Here, the first battery management device 344 may manage and control the entire plurality of battery racks 310 included in the energy storage device 300 and the plurality of second battery management devices 342, and may be referred to as a system battery management device (or SBMS (system battery management system)). Further, each of the plurality of second battery management devices 342 may be connected to each of the plurality of battery racks 310 and manage and control the connected battery racks 310a, 310b, 310n-1, and 310n, and may be referred to as a rack battery management device (or RBMS (rack battery management system)). For example, each of the plurality of second battery management devices 342 may perform measuring the voltage/temperature of the battery cells 312, performing cell balancing of the battery cells 312, measuring the voltage/current and estimating the SOC/SOH of the connected battery racks 310a, 310b, 310n-1, and 310n, and controlling the first switch 332 and the second switch 334 through event detection.

According to some embodiments, the battery management device 340 may transmit a turn-on signal at a predetermined time interval to each of the first switch 332 and the second switch 334 connected between the battery racks 310a, 310b, 310n-1, and 310n and the grid 320 in response to a start signal associated with charging or discharging of the battery racks 310a, 310b, 310n-1, and 310n. For example, the system battery management device 344 may transmit a turn-on signal to the first switch 332 (or the second switch 334) in response to a start signal associated with charging or discharging of the battery rack 310a, 310b, 310n-1, and 310n, and transmit a turn-on signal to the second switch 334 (or the first switch 332) when a predetermined time has elapsed since transmitting the turn-on signal to the first switch 332 (or the second switch 334).

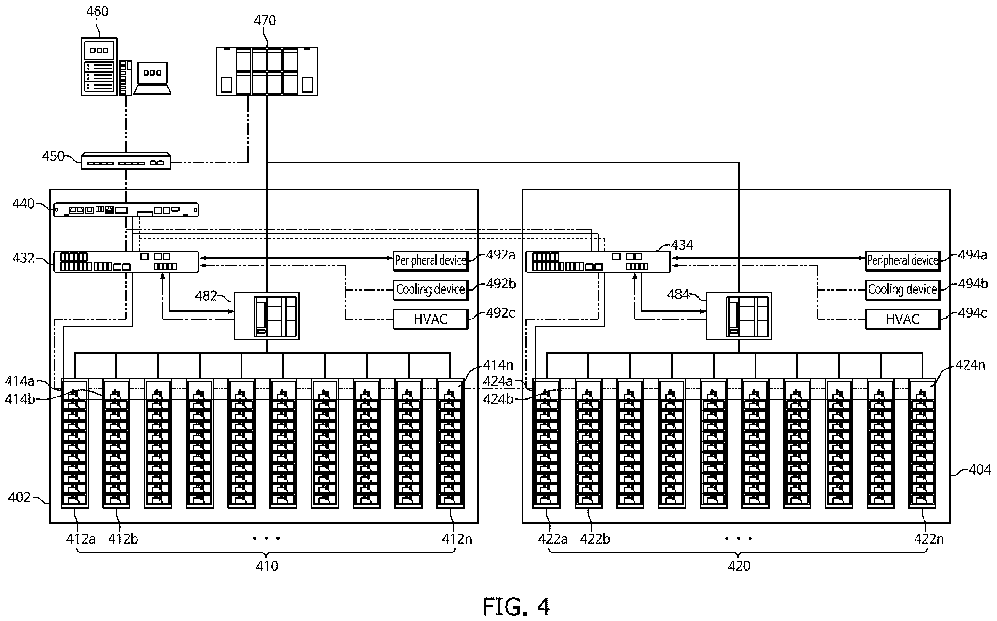

FIG. 4 is a diagram illustrating the configuration of an energy storage device including a plurality of battery containers 402 and 404 according to some embodiments of the present disclosure. Referring to FIG. 4, the energy storage device (or energy storage system) may include a plurality of battery containers 402 and 404, a first battery management device 440 (e.g., the battery management device 240 in FIG. 2 or the battery management device 344 in FIG. 3), a power management device 460, and a power conversion device 470. However, the configuration of the energy storage device is not limited thereto. According to various embodiments, the energy storage device may omit at least one of the components described above and may further include at least one other component.

Each of the plurality of battery containers 402 and 404 may include a plurality of battery racks 410 or 420 (e.g., the battery racks 212, 214, and 216 in FIG. 2 or the battery rack 310 in FIG. 3), a second battery management device 432 or 434, a load break switch 482 or 484, a peripheral device 492a or 494a, a cooling device 492b or 494b, and an HVAC (heating, ventilation and air conditioning) 492c or 494c. However, the configuration of the battery containers 402 and 404 is not limited thereto. According to various embodiments, the battery containers 402 and 404 may omit at least one of the components described above and may further include at least one other component. For example, the first battery management device 440 may be included in any one battery container 402 of the plurality of battery containers 402 and 404. Further, although a structure in which the energy storage device includes the first battery container 402 and the second battery container 404 is described in FIG. 4, the number of battery containers included in the energy storage device is not limited thereto. For example, the energy storage device may further include at least one other third battery container.

Each of the plurality of battery racks 410 and 420 may be formed by having battery modules in which battery cells are connected in series and/or parallel or battery packs including the battery modules connected in series/parallel. According to some embodiments, the plurality of battery racks 410 and 420 may transmit and receive data or signals to and from the first battery management device 440 using a CAN (controller area network) communication protocol. Further, a plurality of battery racks 512a, 512b, 512n, 522a, 522b, and 522n may transmit and receive data or signals to and from one another using the CAN communication protocol. Moreover, the plurality of battery racks 512a, 512b, 512n, 522a, 522b, and 522n may transmit and receive data or signals to and from the second battery management devices 432 and 434 using the CAN communication protocol.

Each of the plurality of battery racks 410 and 420 may include BCUs 414a, 414b, and 414n, or 424a, 424b, and 424n. The BCUs 414a, 414b, and 414n, or 424a, 424b, and 424n are battery control units, and may include a third battery management device, a switch unit, etc. The third battery management device may manage and control the corresponding battery racks 412a, 412b, and 412n, or 422a, 422b, and 422n, and may be referred to as RBMS. The third battery management device may perform measuring the voltage/temperature of the battery cells included in the corresponding battery racks 412a, 412b, and 412n, or 422a, 422b, and 422n, performing cell balancing of the battery cells, measuring the voltage/current and estimating the SOC/SOH of the corresponding battery racks 412a, 412b, and 412n, or 422a, 422b, and 422n, and controlling the switch unit through event detection. The switch unit may electrically connect or disconnect (or selectively connect) the corresponding battery racks 412a, 412b, and 412n, or 422a, 422b, and 422n and the power management device. The switch unit may include, for example, a DC contactor.

The second battery management devices 432 and 434 may perform control of the internal peripheral devices 492a and 494a, control of the RBMS, and control of the load break switches 482 and 484 through event detection of the battery container including the second battery management devices 432 and 434 among the plurality of battery containers 402 and 404. The second battery management devices 432 and 434 may be referred to as a control battery management system (CBMS). The second battery management devices 432 and 434 may detect the states of the corresponding battery container. Further, the second battery management devices 432 and 434 may receive state information indicating the states of the corresponding battery container from at least one of the peripheral devices 492a and 494a, the cooling devices 492b and 494b, the HVACs 492c and 494c, or a fire alarm control panel (FACP) included in or disposed adjacent to the corresponding battery container. At this time, the second battery management devices 432 and 434 may transmit and receive data or signals to and from at least one of the peripheral devices 492a and 494a, cooling devices 492b and 494b, HVACs 492c and 494c, or FACP using a serial communication protocol (e.g., RS485). According to some embodiments, the second battery management devices 432 and 434 may transmit the state information of the corresponding battery container to the first battery management device 440. For example, the second battery management devices 432 and 434 may collect information on the states of the corresponding battery container and transmit the collected information to the first battery management device 440.

The load break switches 482 and 484 may be electrically connected between the plurality of battery racks 410 and 420 and the power conversion device 470, and disconnect or connect the load current. The load break switches 482 and 484 may include, for example, a disconnect switch unit (DSU).

The first battery management device 440 may manage the plurality of battery racks 410 and 420 and the plurality of battery containers 402 and 404 within the energy storage device, and may be referred to as an SBMS. The first battery management device 440 may receive state information indicating the states of each of the plurality of battery containers 402 and 404 from the second battery management devices 432 and 434, and monitor the states of each of the plurality of battery containers 402 and 404 based on the received state information. Further, the first battery management device 440 may control functions associated with internal components (e.g., the plurality of battery racks 410 and 420) of each of the plurality of battery containers 402 and 404 based on the monitoring results. According to some embodiments, the first battery management device 440 may transmit and receive data or signals to and from the power management device 460 and the power conversion device 470 via a hub 450. At this time, the communication protocol used may include, for example, the Modbus TCP/IP communication protocol.

According to some embodiments, the first battery management device 440 may be included in any one of the plurality of battery containers 402 and 404. For example, the first battery management device 440 may be included in the first battery container 402.

The first battery management device 440 may transmit a turn-on signal at a predetermined first time interval to each of a plurality of switch units that electrically connects or disconnects each of the plurality of battery racks 410 and 420 and the power supply in response to a start signal associated with charging or discharging of the plurality of battery racks 410 and 420 included in each of the plurality of battery containers 402 and 404. Here, a single power supply may be included in each of the plurality of battery containers 402 and 404. For example, the first battery container 402 may include a first power supply, and the second battery container 404 may include a second power supply. Further, the switch unit may be included in the BCUs 414a, 414b, 414n, 424a, 424b, and 424n, and may include a first switch and a second switch. Moreover, the first time interval may be determined based on at least one of the number of the plurality of battery racks 410 and 420 or the inrush current due to the electrical connection between each of the plurality of battery racks 410 and 420 and the power supply.

According to some embodiments, the transmission time intervals of the turn-on signals transmitted to each of the plurality of switch units that electrically connects or disconnects each of the plurality of battery racks 410 and 420 and the power supply included in each of the plurality of battery containers 402 and 404 may be different or the same. As one example, the transmission time interval of the turn-on signals transmitted to each of the plurality of first switch units that electrically connects or disconnects the plurality of battery racks 410 and the first power supply included in the first battery container 402 may be a first time interval, and the transmission time interval of the turn-on signals transmitted to each of the plurality of second switch units that electrically connects or disconnects the plurality of battery racks 420 and the second power supply included in the second battery container 404 may be a second time interval different from the first time interval. As another example, the transmission time interval of the turn-on signals transmitted to each of the plurality of first switch units that electrically connects or disconnects the plurality of battery racks 410 and the first power supply included in the first battery container 402 may be a first time interval, and the transmission time interval of the turn-on signals transmitted to each of the plurality of second switch units that electrically connects or disconnects the plurality of battery racks 420 and the second power supply included in the second battery container 404 may also be the first time interval.

According to some embodiments, the first battery management device 440 may transmit a turn-on signal at a predetermined second time interval to each of the first switch and the second switch included in the switch unit associated with the corresponding battery rack in response to a start signal associated with charging or discharging of each of the plurality of battery racks 410 and 420. Here, the second time interval may be determined based on the inrush current due to the electrical connection between the corresponding battery rack and the power supply.

The power management device 460 (or a power management system (PMS) or an energy management system (EMS)) may manage the power supplied to the energy storage device. For example, the power management device 460 may manage the power of the components (e.g., the plurality of battery racks 410 and 420, the first battery management device 440, and the power conversion device 470) within the plurality of battery containers 402 and 404.

The power conversion device 470 (or power conversion system (PCS)) may convert the form of electric energy and supply it to suit the requirements of the power system. For example, the power conversion device 470 may convert AC power from an external power source into DC power and store (or charge) it in the plurality of battery racks 410 and 420, and may convert the DC power stored in the plurality of battery racks 410 and 420 into AC power and supply (or discharge) it to an external system.

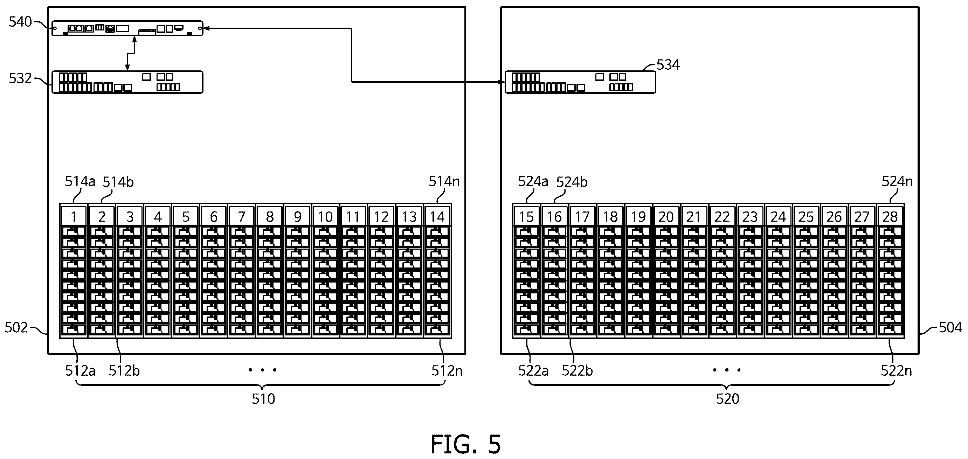

FIG. 5 is a diagram illustrating a method for determining the order of battery racks according to some embodiments of the present disclosure. Referring to FIG. 5, a first battery management device 540 (e.g., SBMS) of an energy storage device (or energy storage system) may determine a start order of charging or discharging a plurality of battery racks 510 and 520 included in each of a plurality of battery containers 502 and 504. In order to determine this order, the first battery management device 540 may receive configuration information including identification information of each of a plurality of battery racks 512a, 512b, 512n, 522a, 522b, and 522n included in the corresponding battery container and information on the number of the plurality of battery racks 512a, 512b, 512n, 522a, 522b, and 522n included in the corresponding battery container from second battery management devices 532 and 534 included in each of the plurality of battery containers 502 and 504, and determine the order of the plurality of battery racks 512a, 512b, 512n, 522a, 522b, and 522n included in the corresponding battery container based on the configuration information received. For example, the first battery management device 540 may receive first configuration information including identification information of each of the plurality of battery racks 512a, 512b, and 512n and information on the number of the plurality of battery racks 512a, 512b, and 512n from the second battery management device 532 included in the first battery container 502, and may determine the order (hereinafter referred to as a first order) of the plurality of battery racks 512a, 512b, and 512n based on the first configuration information received. Further, the first battery management device 540 may receive second configuration information including identification information of each of the plurality of battery racks 522a, 522b, and 522n and information on the number of the plurality of battery racks 522a, 522b, and 522n from the second battery management device 534 included in the second battery container 504, and may determine the order (hereinafter referred to as a second order) of the plurality of battery racks 522a, 522b, and 522n based on the second configuration information received.

Then, the first battery management device 540 may transmit a turn-on signal at a predetermined time interval to each of a plurality of switch units that electrically connects or disconnects the plurality of battery racks 512a, 512b, 512n, 522a, 522b, and 522n and the power supply based on the determined orders (the first order and second order). For example, the first battery management device 540 may transmit a turn-on signal in sequence at a predetermined first time interval to each of a plurality of first switch units that electrically connects or disconnects the plurality of battery racks 512a, 512b, and 512n and a first power supply based on the determined first order. Further, the first battery management device 540 may transmit a turn-on signal in sequence at a predetermined second time interval to each of a plurality of second switch units that electrically connects or disconnects the plurality of battery racks 522a, 522b, and 522n and a second power supply based on the determined second order. At this time, the first time interval and the second time interval may be the same or different from each other.

According to some embodiments, the first battery management device 540 may match the n-th battery rack according to the first order among the plurality of battery racks 512a, 512b, and 512n with the n-th battery rack according to the second order among the plurality of battery racks 522a, 522b, and 522n. In this circumstance, the n may be the smaller natural number out of the number of the plurality of battery racks 512a, 512b, and 512n and the number of the plurality of battery racks 522a, 522b, and 522n. FIG. 5 shows a state where the number (n) of the plurality of battery racks 512a, 512b, and 512n included in the first battery container 502 and the number (n) of the plurality of battery racks 522a, 522b, and 522n included in the second battery container 504 are the same, being 14.

According to some embodiments, the first battery management device 540 may simultaneously transmit a turn-on signal to a first switch unit associated with the matched battery rack of the plurality of first switch units that electrically connects or disconnects the plurality of battery racks 512a, 512b, and 512n and the first power supply, and a second switch unit associated with the matched battery rack of the plurality of second switch units that electrically connects or disconnects the plurality of battery racks 522a, 522b, and 522n and the second power supply. For example, the first battery management device 540 may simultaneously transmit a turn-on signal to a 1-1 or first switch unit that electrically connects or disconnects the first battery rack 512a of the plurality of battery racks 512a, 512b, and 512n included in the first battery container 502 and the first power supply, and a 2-1 or third switch unit that electrically connects or disconnects the first battery rack 522a of the plurality of battery racks 522a, 522b, and 522n included in the second battery container 504 and the second power supply. Then, after a predetermined time has elapsed, the first battery management device 540 may simultaneously transmit a turn-on signal to a 1-2 or second switch unit that electrically connects or disconnects the second battery rack 512b of the plurality of battery racks 512a, 512b, and 512n included in the first battery container 502 and the first power supply, and a 2-2 or fourth switch unit that electrically connects or disconnects the second battery rack 522a of the plurality of battery racks 522a, 522b, and 522n included in the second battery container 504 and the second power supply. In this way, the first battery management device 540 may simultaneously transmit a turn-on signal to a 1-n switch unit that electrically connects or disconnects the n-th battery rack 512n of the plurality of battery racks 512a, 512b, and 512n included in the first battery container 502 and the first power supply, and a 2-n switch unit that electrically connects or disconnects the n-th battery rack 522n of the plurality of battery racks 522a, 522b, and 522n included in the second battery container 504 and the second power supply, up to the n-th battery racks 512n and 522n at a predetermined time interval. As described above, by simultaneously controlling the switch units associated with the plurality of battery racks 512a, 512b, 512n, 522a, 522b, and 522n included in each battery container 502 and 504 according to the matching order, multiple battery containers can be controlled in the time it takes to control a single battery container.

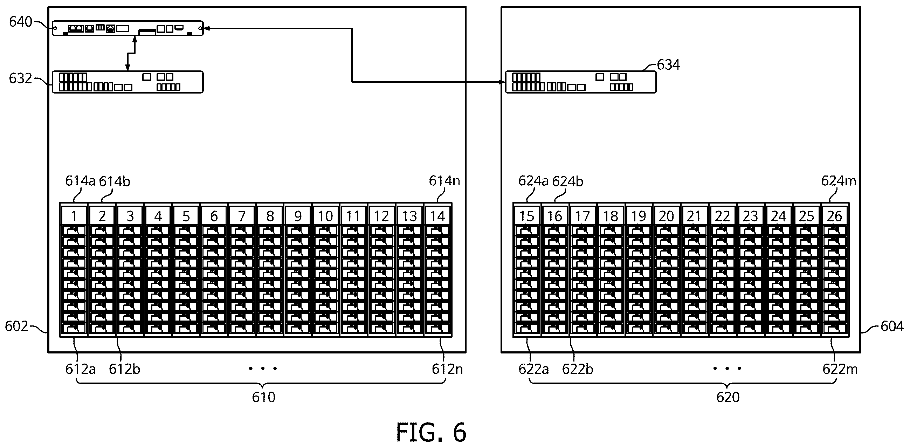

FIG. 6 is a diagram illustrating a method for determining the order of different numbers of battery racks according to some embodiments of the present disclosure. Referring to FIG. 6, a method for determining the order of battery racks 610 and 620 when a plurality of battery containers 602 and 604 includes different numbers of battery racks 610 and 620 will be described. In FIG. 6, descriptions of the same or similar configurations described in FIG. 5 may be omitted.

Referring to FIG. 6, a first battery management device 640 (e.g., SBMS) of an energy storage device (or energy storage system) may determine a start order of charging or discharging a plurality of battery racks 610 and 620 included in each of a plurality of battery containers 602 and 604. In order to determine this order, the first battery management device 640 may receive configuration information including identification information of each of a plurality of battery racks 612a, 612b, 612n, 622a, 622b, and 622m included in the corresponding battery container and information on the number of the plurality of battery racks 612a, 612b, 612n, 622a, 622b, and 622m included in the corresponding battery container from second battery management devices 632 and 634 included in each of the plurality of battery containers 602 and 604, and determine the order of the plurality of battery racks 612a, 612b, 612n, 622a, 622b, and 622m included in the corresponding battery container based on the configuration information received. FIG. 6 shows a state where the number (n) of the plurality of battery racks 612a, 612b, and 612n included in the first battery container 602 is 14, and the number (m) of the plurality of battery racks 622a, 622b, and 622m included in the second battery container 604 is 12, which is different from the former.

In this circumstance as well, the first battery management device 640 may simultaneously transmit a turn-on signal to a first switch unit associated with a matched battery rack of a plurality of first switch units that electrically connects or disconnects the plurality of battery racks 612a, 612b, and 612n and the first power supply, and a second switch unit associated with a matched battery rack of a plurality of second switch units that electrically connects or disconnects the plurality of battery racks 622a, 622b, and 622m and the second power supply. For example, the first battery management device 640 may simultaneously transmit a turn-on signal to a 1-1 or first switch unit that electrically connects or disconnects the first battery rack 612a of the plurality of battery racks 612a, 612b, and 612n included in the first battery container 602 and the first power supply, and a 2-1 or third switch unit that electrically connects or disconnects the first battery rack 622a of the plurality of battery racks 622a, 622b, and 622m included in the second battery container 604 and the second power supply. Then, after a predetermined time has elapsed, the first battery management device 640 may simultaneously transmit a turn-on signal to a 1-2 or second switch unit that electrically connects or disconnects the second battery rack 612b of the plurality of battery racks 612a, 612b, and 612n included in the first battery container 602 and the first power supply, and a 2-2 or fourth switch unit that electrically connects or disconnects the second battery rack 622a of the plurality of battery racks 622a, 622b, and 622m included in the second battery container 604 and the second power supply. In this way, the first battery management device 640 may simultaneously transmit a turn-on signal to a 1-m or 1-m-th switch unit that electrically connects or disconnects the m-th battery rack of the plurality of battery racks 612a, 612b, and 612n included in the first battery container 602 and the first power supply, and a 2-m switch unit that electrically connects or disconnects the m-th battery rack 622m of the plurality of battery racks 622a, 622b, and 622m included in the second battery container 604 and the second power supply, up to the m-th battery rack 622m (when n > m) at a predetermined time interval. Then, after a predetermined time has elapsed, the first battery management device 640 may transmit turn-on signals in sequence to the switches that have not received the turn-on signal. For example, the first battery management device 640 may transmit turn-on signals in sequence at a predetermined time interval, from a 1-(m+1) switch unit that electrically connects or disconnects the (m+1)th battery rack of the plurality of battery racks 612a, 612b, and 612n included in the first battery container 602 and the first power supply to a 1-n switch unit that electrically connects or disconnects the n-th battery rack of the plurality of battery racks 612a, 612b, and 612n included in the first battery container 602 and the first power supply. As described above, by simultaneously controlling the switch units associated with the plurality of battery racks 612a, 612b, 612n, 622a, 622b, and 622m included in each battery container 602 and 604 according to the matching order but controlling based on the battery container having the larger number of battery racks (e.g., the first battery container 602), multiple battery containers can be controlled in the time it takes to control a single battery container having the largest number of battery racks.

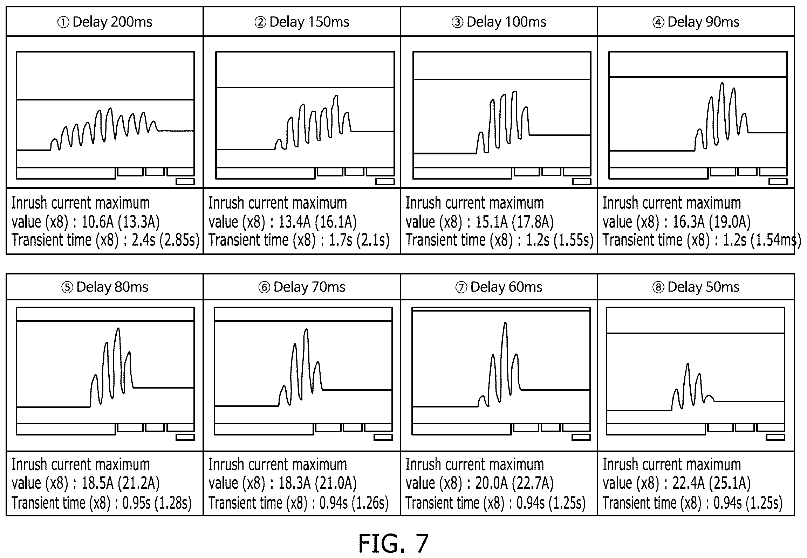

FIG. 7 is a diagram illustrating the magnitude of inrush currents according to transmission time intervals of turn-on signals according to some embodiments of the present disclosure. The graphs shown in FIG. 7 are current values measured at the output DC 24 V terminals of an SMPS, where a power supply (e.g., the power supply 230 in FIG. 2) is the SMPS, and are graphs obtained by measuring the inrush current and transient time when a turn-on signal is transmitted at a predetermined time interval (Delay in FIG. 7) to each of switch units (e.g., the switch units 222, 224, and 226 in FIG. 2, the switches 332 and 334 in FIG. 3, the switch units included in the BCUs 414a, 414b, 414n, 424a, 424b, and 424n in FIG. 4, the switch units included in the BCUs 514a, 514b, 514n, 524a, 524b, and 524n in FIG. 5, or the switch units included in the BCUs 614a. 614b. 614n, 624a, 614b, and 624m in FIG. 6) between a plurality of battery racks (e.g., the battery racks 212, 214, and 216 in FIG. 2, the battery rack 310 in FIG. 3, the battery racks 410 and 420 in FIG. 4, the battery racks 510 and 520 in FIG. 5, or the battery racks 610 and 620 in FIG. 6) and the SMPS.

Referring to FIG. 7, as the transmission time interval (Delay in FIG. 7) of the turn-on signals between the switch units between the plurality of battery racks and the SMPS gets shorter, the inrush current maximum value (peak current value) may increase and the transient time may decrease. Based on such experimental data, the capacity of the power supply and the time interval of the turn-on signal between the switch units may be determined.

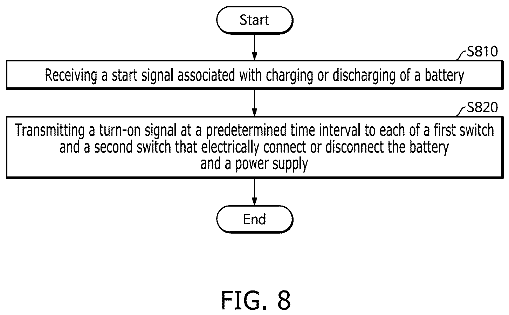

FIG. 8 is a diagram illustrating a method of controlling a battery management device according to some embodiments of the present disclosure. Referring to FIG. 8, a control circuit (e.g., the control circuit 120 in FIG. 1) of a battery management device (e.g., the battery management device 100 in FIG. 1) may receive a start signal associated with charging or discharging of a battery (e.g., the battery 102 in FIG. 1) in step 810 (S810).

In step 820 (S820), the control circuit may transmit a turn-on signal at a predetermined time interval to each of a first switch (e.g., the first switch 106 in FIG. 1) and a second switch (e.g., the second switch 108 in FIG. 1) that electrically connect or disconnect (or selectively connect) the battery and a power supply (e.g., the power supply 104 in FIG. 1). Here, the first switch and the second switch may include a DC contactor. For example, the control circuit may transmit a turn-on signal to the first switch connected between the battery and the power supply in response to a start signal associated with charging or discharging of the battery, and transmit a turn-on signal to the second switch connected between the battery and the power supply when a predetermined time has elapsed since transmitting the turn-on signal to the first switch. At this time, the transmission time interval of the turn-on signal transmitted to each of the first switch and the second switch may be determined based on the inrush current due to the electrical connection between the battery and the power supply. As described above, the inrush current can be reduced by transmitting turn-on signals at a predetermined time interval to each of the switches (e.g., the first switch and the second switch) that electrically connect or disconnect the battery and the power supply, and as the inrush current is reduced, the capacity of the power supply can also be designed to be smaller.

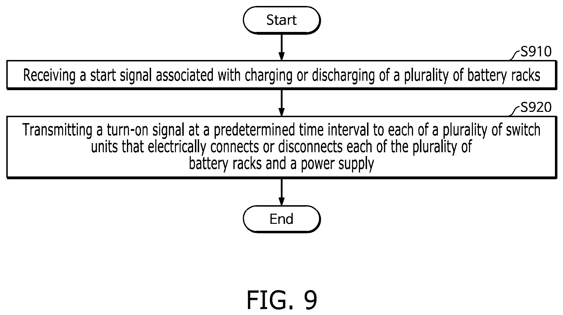

FIG. 9 is a diagram illustrating a method of controlling an energy storage device according to some embodiments of the present disclosure. Referring to FIG. 9, a battery management device (e.g., the battery management device 240 in FIG. 2) of an energy storage device (or energy storage system) (e.g., the energy storage device in FIG. 2) may receive a start signal associated with charging or discharging of a plurality of battery racks (e.g., the battery racks 212, 214, and 216 in FIG. 2) in step 910 (S910).

In step 920 (S920), the battery management device may transmit a turn-on signal at a predetermined time interval to each of a plurality of switch units (e.g., the switch units 222, 224, and 226 in FIG. 2) that electrically connects or disconnects (or selectively connects) each of a plurality of battery racks and a power supply (e.g., the power supply 230 in FIG. 2). For example, the battery management device may transmit a turn-on signal to a first switch unit (e.g., the switch unit 222 in FIG. 2) connected between a first battery rack (e.g., the battery rack 212 in FIG. 2) and the power supply among the plurality of switch units in response to a start signal associated with charging or discharging of the plurality of battery racks, and transmit a turn-on signal to a second switch unit (e.g., the switch unit 224 in FIG. 2) connected between a second battery rack (e.g., the battery rack 214 in FIG. 2) and the power supply among the plurality of switch units when a predetermined time has elapsed since transmitting the turn-on signal to the first switch unit. In this way, the battery management device may transmit turn-on signals in sequence at a predetermined time interval to each of the plurality of switch units, up to another switch unit (e.g., the switch unit 226 in FIG. 2) connected between another battery rack (e.g., the battery rack 216 in FIG. 2) and the power supply. At this time, the transmission time interval of the turn-on signals transmitted to each of the plurality of switch units may be determined based on at least one of the number of the plurality of battery racks or the inrush current due to the electrical connection between each of the plurality of battery racks and the power supply. As described above, the inrush current can be reduced by transmitting turn-on signals at a predetermined time interval to each of the plurality of switch units that electrically connects or disconnects the power supply and each of the plurality of battery racks, and as the inrush current is reduced, the capacity of the power supply 230 can also be designed to be smaller.

According to some embodiments, the battery management device may transmit a turn-on signal at a predetermined time interval to each of a first switch (e.g., the first switch 222a, 224a, or 226a in FIG. 2) and a second switch (e.g., the second switch 222b, 224b, or 226b in FIG. 2) that electrically connect or disconnect (or selectively connect) the corresponding battery rack and the power supply in response to a start signal associated with charging or discharging of each of the plurality of battery racks. For example, the battery management device may transmit a turn-on signal to the first switch (e.g., the first switch 222a in FIG. 2) between the first battery rack and the power supply in response to a start signal associated with charging or discharging of the first battery rack, and transmit a turn-on signal to the second switch (e.g., the second switch 222b in FIG. 2) when a predetermined time has elapsed since transmitting the turn-on signal to the first switch. Further, the battery management device may transmit a turn-on signal to the first switch (e.g., the first switch 224a in FIG. 2) between the second battery rack and the power supply in response to a start signal associated with charging or discharging of the second battery rack, and transmit a turn-on signal to the second switch (e.g., the second switch 224b in FIG. 2) when a predetermined time has elapsed since transmitting the turn-on signal to the first switch. In this way, the battery management device may transmit a turn-on signal to the first switch (e.g., the first switch 226a in FIG. 2) between the corresponding battery rack and the power supply in response to a start signal associated with charging or discharging of the corresponding battery rack, and transmit a turn-on signal to the second switch (e.g., the second switch 226b in FIG. 2) when a predetermined time has elapsed since transmitting the turn-on signal to the first switch, up to another battery rack (e.g., the battery rack 216 in FIG. 2). At this time, the transmission time interval of the turn-on signals transmitted to the first switch and the second switch included in each of the plurality of switch units may be determined based on the inrush current due to the electrical connection between the corresponding battery rack and the power supply. As described above, not only can turn-on signals be transmitted to the plurality of switch units, at a predetermined time interval between them, connected between each of the plurality of battery racks and the power supply, but also turn-on signals can be transmitted to the first switch and the second switch, at a predetermined time interval between them, included in each of the plurality of switch units. Accordingly, the inrush current can be reduced, and as the inrush current is reduced, the capacity of the power supply can also be designed to be smaller.

According to the embodiments of the present disclosure, the inrush current can be reduced by transmitting turn-on signals at a predetermined time interval to each of the switches that electrically connect or disconnect the battery and the power supply, and as the inrush current is reduced, the capacity of the power supply can also be reduced.

Furthermore, according to the present disclosure, the inrush current can be reduced by transmitting turn-on signals at a predetermined time interval to each of the plurality of switch units that electrically connects or disconnects the power supply and each of the plurality of battery racks, and as the inrush current is reduced, the capacity of the power supply can also be reduced.

However, the aspects and features of the present disclosure are not limited to those described above, and other aspects and features not expressly described herein will be clearly understood by a person skilled in the art from the description of example embodiments of the present disclosure described below.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims, below.

## Claims

1. A battery management device (100) comprising:
a detection circuit (110) configured to detect a state of a battery (102); and
a control circuit (120) configured to monitor the state of the battery (102) and control functions associated with the battery (102);
wherein the control circuit (120) is configured to transmit turn-on signals at a predetermined time interval to each of a first switch (106) and a second switch (108) that electrically connect or disconnect the battery (102) and a power supply (104) in response to a start signal associated with charging or discharging of the battery (102).

2. The battery management device (100) as claimed in claim 1, wherein the predetermined time interval is determined based on an inrush current due to an electrical connection between the battery (102) and the power supply (104).

3. An energy storage device (300) comprising:
a first battery container (402, 502, 602) comprising a plurality of first battery racks (410, 510, 610) connected in parallel to one another and a first power supply that supplies power to the plurality of first battery racks (212, 214, 216, 310, 410, 510, 610); and
a first battery management device (240, 340, 440, 540, 640);
wherein the first battery management device (240, 340, 440, 540, 640) is configured to transmit turn-on signals at a predetermined first time interval to each of a plurality of first switch units that electrically connects or disconnects each of the plurality of first battery racks (212, 214, 216, 310, 410, 510, 610) and the first power supply in response to a start signal associated with charging or discharging of the plurality of first battery racks (212, 214, 216, 310, 410, 510, 610).

4. The energy storage device (300) as claimed in claim 3, wherein the predetermined first time interval is determined based on the number of the plurality of first battery racks (212, 214, 216, 310, 410, 510, 610) and/or an inrush current due to an electrical connection between each of the plurality of first battery racks (212, 214, 216, 310, 410, 510, 610) and the first power supply.

5. The energy storage device (300) as claimed in claim 3 or 4, wherein each of the plurality of first switch units (222) comprises a first switch (222a, 332) and a second switch (22b, 334) that electrically connect or disconnect a corresponding battery rack (212, 310a) of the plurality of first battery racks (212, 214, 216, 310, 410, 510, 610) and the first power supply, and
the first battery management device (240, 440, 540, 640) is configured to transmit turn-on signals at a predetermined second time interval to each of the first switch (222a, 332) and the second switch (22b, 334) in response to a start signal associated with charging or discharging of the battery rack (212, 214, 216, 310, 410, 510, 610).

6. The energy storage device (300) as claimed in any of claims 3 to 4, wherein the first battery management device (240, 340, 440, 540, 640) is included in the first battery container (402, 502, 602).

7. The energy storage device (300) as claimed in claim 6, further comprising:
a second battery container (404, 504, 604) comprising a plurality of second battery racks (420, 520, 620) connected in parallel to one another and a second power supply that supplies power to the plurality of second battery racks (420, 520, 620).

8. The energy storage device (300) as claimed in claim 7, wherein the first battery management device (240, 340, 440, 540, 640) is configured to transmit turn-on signals at a predetermined third time interval to each of a plurality of second switch units (224) that electrically connects or disconnects each of the plurality of second battery racks (420, 520, 620) and the second power supply in response to a start signal associated with charging or discharging of the plurality of second battery racks (420, 520, 620).

9. The energy storage device (300) as claimed in claim 8, wherein the predetermined third time interval is determined based on at least one of the number of the plurality of second battery racks (420, 520, 620) or an inrush current due to an electrical connection between each of the plurality of second battery racks (420, 520, 620) and the second power supply.

10. The energy storage device (300) as claimed in claim 8 or 9, wherein the predetermined third time interval is the same as the predetermined first time interval.

11. The energy storage device (300) as claimed in any of claims 8 to 10, wherein the first battery container (402, 502, 602) further comprises a second battery management device (432, 532, 632) configured to control functions associated with the first battery container (402, 502, 602), and
the second battery container (404, 504, 604) further comprises a third battery management device (434, 534, 634) configured to control functions associated with the second battery container (404, 504, 604), and
wherein the first battery management device (440, 540, 640) is configured to:
receive first configuration information comprising identification information of each of the plurality of first battery racks (410, 510, 610) and information on the number of the plurality of first battery racks (410, 510, 610) from the second battery management device (432, 532, 632), and determine a first order of the plurality of first battery racks (410, 510, 610) based on the first configuration information, and
receive second configuration information comprising identification information of each of the plurality of second battery racks (420, 520, 620) and information on the number of the plurality of second battery racks (420, 520, 620) from the third battery management device (434, 534, 634), and determine a second order of the plurality of second battery racks (420, 520, 620) based on the second configuration information.

12. The energy storage device (300) as claimed in claim 11, wherein the first battery management device (440, 540, 640) is configured to:
transmit turn-on signals in sequence at the predetermined first time interval to each of the plurality of first switch units based on the determined first order, and
transmit turn-on signals in sequence at the predetermined third time interval to each of the plurality of second switch units based on the determined second order.

13. The energy storage device (300) as claimed in claim 12, wherein the first battery management device (440, 540, 640) is configured to:
match an n-th battery rack (412n, 512n, 612n) according to the first order among the plurality of first battery racks (410, 510, 610) with the n-th battery rack (422n, 522n, 622n) according to the second order among the plurality of second battery racks (420, 520, 620), wherein n is a natural number that is smaller than the total number of the plurality of first battery racks (410, 510, 610) and the total number of the plurality of second battery racks (420, 520, 620), and
transmit turn-on signals simultaneously to a first switch unit associated with the matched battery rack (412a...n) of the plurality of first switch units and a second switch unit associated with the matched battery rack (422a...n) of the plurality of second switch units.

14. A method of controlling an energy storage device (300), comprising:
receiving (S810) a start signal associated with charging or discharging of a plurality of first battery racks (212, 214, 216, 410, 510, 610) included in a first battery container (402, 502, 602) and connected in parallel to one another; and
transmitting (S820) turn-on signals at a predetermined first time interval to each of a plurality of first switch units (222a, 224a, 226a) that electrically connects or disconnects each of the plurality of first battery racks (212, 214, 216, 410, 510, 610) and a first power supply (230) included in the first battery container (402, 502, 602) and supplying power to the plurality of first battery racks (212, 214, 216, 410, 510, 610), in response to the received start signal.

15. The method as claimed in claim 14, wherein the predetermined first time interval is determined based on at least one of the number of the plurality of first battery racks (212, 214, 216, 410, 510, 610) or an inrush current due to an electrical connection between each of the plurality of first battery racks (212, 214, 216, 410, 510, 610) and the first power supply (230).
